# EUROPÄISCHE PATENTSCHRIFT

(11) **EP 0 643 332 B1**
(45) Veröffentlichungstag und Bekanntmachung des Hinweises auf die Patenterteilung: **29.01.1997**
(21) Anmeldenummer: 94113031.2
(22) Anmeldetag: 20.08.1994
(51) Int. Cl.: G03F 3/10, G03F 7/34

(54) **Lichtempfindliches Material und Verfahren zur Herstellung eines farbigen Bilds**
Light-sensitive material and process for making a coloured image
Matériau photosensible et procédé pour fabriquer une image en couleurs

(30) Priorität: 26.08.1993 DE 4328676
(43) Veröffentlichungstag der Anmeldung: 15.03.1995
(73) Patentinhaber: Agfa-Gevaert AG, D-51373 Leverkusen (DE)
(72) Erfinder: Platzer, Stephan, J. W., Dr., Califon, New Jersey 07830 (US); Buchmann, Andrea, D-65203 Wiesbaden (DE); Buhr, Gerhard, Dr., D-61462 Königstein (DE)

(56) Entgegenhaltungen:
- EP-A- 0 031 566
- EP-A- 0 451 736
- WO-A-93/15438

## Beschreibung

Die Erfindung betrifft ein lichtempfindliches Material, das zur Herstellung von farbigen Bildern, insbesondere zur Farbprüfung für den Mehrfarbendruck geeignet ist. Sie betrifft ferner ein Verfahren zur Herstellung eines farbigen Bilds, insbesondere ein Farbprüfverfahren, bei dem ein lichtempfindliches Material aus einer transparenten Trägerfolie, einer farbigen lichtempfindlichen Schicht und einer thermoplastischen Haftschicht auf ein Bildempfangsblatt laminiert, durch die Trägerfolie hindurch bildmäßig belichtet und durch Abziehen der Trägerfolie, zusammen mit den unbelichteten Bereichen der farbigen lichtempfindlichen Schicht, zum Bild entwickelt wird ("peel-apart"-Entwicklung). Aus mehreren auf diese Weise erhaltenen Teilfarbenbildern kann ein Mehrfarbenbild aufgebaut werden.

Materialien der vorstehend genannten allgemeinen Gattung sind z. B. in der US-A 5 108 868 beschrieben. Dort wird ein lichtempfindliches Material auf Basis von Diazoniumsalzen eingesetzt, das erhaltene Teilfarbenbild muß nochmals auf ein endgültiges Bildempfangsmaterial übertragen werden, und die weiteren Teilfarbenbilder müssen im Register auf das erste laminiert werden.

In der US-A 4 923 780 wird ein Farbprüfverfahren beschrieben, bei dem ein Teilfarbenbild aus einer farbigen photopolymerisierbaren Schicht erzeugt wird, die eine aromatische o-Nitroverbindung enthält, die bei Belichtung mit kurzwelliger UV-Strahlung einen Polymerisationsinhibitor bildet. Durch Bildbelichtung mit kurzwelliger UV-Strahlung und Belichtung ohne Vorlage mit langwelliger UV-Strahlung wird eine Bildumkehr erreicht. Das negative Mehrfarbenbild kann durch Laminieren auf ein Bildempfangsmaterial, Belichten im Register und Entwickeln durch Auseinanderziehen der einzelnen Teilfarbenbilder erreicht werden.

In der EP-A 514 186 wird ebenfalls ein negativ arbeitendes Farbprüfverfahren beschrieben, bei dem die Bildentwicklung durch Auseinanderziehen erfolgt. Hier wird aus einem photopolymerisierbaren Material eine Bildumkehr durch zweimaliges Laminieren und zweimaliges Belichten, einmal mit und einmal ohne Vorlage, erreicht.

Aufgabe der Erfindung war es, ein negativ arbeitendes Farbprüfverfahren sowie ein hierfür geeignetes lichtempfindliches Material vorzuschlagen, das es ermöglicht, die Vorteile der bisher bekannten Verfahren mit einfacheren Mitteln zu erreichen.

Die Erfindung geht aus von einem lichtempfindlichen Material mit
(A) einer flexiblen transparenten Trägerfolie,
(B) einer farbigen lichtempfindlichen Schicht, die ein organisches Bindemittel (B1) und einen Farbstoff oder ein Farbpigment (B2) enthält, und
(C) einer Haftschicht, die ein thermoplastisches Polymeres enthält und eine Erweichungstemperatur im Bereich von 40 bis 200 °C hat,
wobei die Haftung (a₁) der unbelichteten lichtempfindlichen Schicht (B) an der Haftschicht (C) kleiner ist als die Haftung (a₃) der unbelichteten lichtempfindlichen Schicht (B) an der Trägerfolie (A) und als die Kohäsionen der Schichten (B) und (C) und wobei die Haftung (a₃') der belichteten lichtempfindlichen Schicht (B) an der Trägerfolie (A) kleiner ist als die Haftung (a₁') der belichteten lichtempfindlichen Schicht (B) an der Haftschicht (C) sowie als die Kohäsionen der Haftschicht (C) und der belichteten lichtempfindlichen Schicht (B).

Das erfindungsgemäße Material ist dadurch gekennzeichnet, daß die farbige lichtempfindliche Schicht (B) ferner eine Verbindung (B3), die bei Bestrahlung eine starke Säure bildet, und eine Verbindung (B4) enthält, die mindestens eine durch Säure spaltbare Gruppe aufweist.

Erfindungsgemäß wird ferner ein Verfahren zur Herstellung eines farbigen Bilds vorgeschlagen, bei dem man ein lichtempfindliches Material aus
(A) einer flexiblen transparenten Trägerfolie,
(B) einer farbigen lichtempfindlichen Schicht, die ein organisches Bindemittel (B1) und einen Farbstoff oder ein Farbpigment (B2) enthält, und
(C) einer Haftschicht, die ein thermoplastisches Polymeres enthält und eine Erweichungstemperatur im Bereich von 40 bis 200 °C hat,
mit der Haftschicht (C) unter Druck und bei erhöhter Temperatur auf ein Bildempfangsblatt (D) laminiert, das erhaltene Laminat durch die Trägerfolie (A) hindurch bildmäßig belichtet und die Trägerfolie zusammen mit den unbelichteten Schichtbereichen der lichtempfindlichen Schicht (B) von dem Bildempfangsblatt (D) abzieht, wobei die Haftung (a₁) der unbelichteten lichtempfindlichen Schicht (B) an der Haftschicht (C) kleiner ist als die Haftung (a₂) der Haftschicht (C) an dem Bildempfangsblatt (D) und die Haftung (a₃) der unbelichteten lichtempfindlichen Schicht (B) an der Trägerfolie (A) und die Kohäsionen der Schichten (B) und (C) und wobei die Haftung (a₃') der belichteten lichtempfindlichen Schicht (B) an der Trägerfolie (A) kleiner ist als die Haftung (a₂) der Haftschicht (C) an dem Bildempfangsblatt (D) und die Haftung (a₁') der belichteten lichtempfindlichen Schicht (B) an der Haftschicht (C) sowie als die Kohäsionen der Haftschicht (C) und der belichteten lichtempfindlichen Schicht (B).

Das erfindungsgemäße Verfahren ist dadurch gekennzeichnet, daß man ein lichtempfindliches Material mit einer farbigen lichtempfindlichen Schicht (B) einsetzt, die eine Verbindung (B3), die bei Bestrahlung eine starke Säure bildet, und eine Verbindung (B4) enthält, die mindestens eine durch Säure spaltbare Gruppe aufweist.

Die Verbindung (B3), die bei Bestrahlung eine starke Säure bildet, ist bevorzugt eine lichtempfindliche organische Halogenverbindung, die mehr als ein Halogenatom an einem aliphatischen Kohlenstoffatom oder an einem aromatischen Ring enthält. Besonders wirksam sind Trihalogenmethylverbindungen, z. B. Trichlor- und Tribrommethylverbindungen, besonders solche, in denen die Trihalogenmethylgruppe an einem heterocyclischen Ring, z. B. einem s-Triazinring oder einem Thiazolinring steht. Geeignete Verbindungen dieses Typs sind in den US-A 3 954 475, 4 189 323 und 4 619 998 beschrieben.

Weitere als Säurebildner geeignete Verbindungen sind Sulfonsäurederivate, wie Ester, z. B. o-Nitrobenzylester; Amide und Imide. Derartige Verbindungen sind u. a. beschrieben bei Houlihan et al in Macromolecules, Bd. 21, S. 2001-2006 (1988), der EP-A 510 446 und den US-A 4 618 674 und 4 731 605.

Auch viele Oniumsalze sind für diesen Zweck beschrieben worden [J. Crivello, Polym. Eng. Sci., 23 (1983), 953].

Die säurebildende Komponente ist in der Schicht (B) in einer Menge von 2 bis 30, bevorzugt 5 bis 20 Gew.-% enthalten.

Die Verbindung (B4) mit mindestens einer durch Säure spaltbaren Gruppe ist ebenfalls an sich bekannt. Im allgemeinen werden Verbindungen mit säurespaltbaren C-O-C-Gruppen eingesetzt. Solche Verbindungen können vor allem Orthocarbonsäureester, Carbonsäureamidacetale, Acetale oder Ketale sein. Auch Enolether, N-Acyliminocarbonate, Ether tertiärer Alkohole und Carbonsäure- oder Kohlensäureester von tertiären Alkoholen, Allylalkohol oder Benzylalkoholen sind geeignet. Auch Verbindungen mit säurespaltbaren C-O-Si-Gruppen, z. B. mit Silylethergruppen oder Silyl-enolethergruppen, können hierfür eingesetzt werden. Geeignete säurespaltbare Verbindungen sind bekannt und u.a. in den US-A 4 189 323, 4 311 782, 4 247 611, 4 250 247 und 4 248 957 und der EP-A 510 448 beschrieben. Von den säurespaltbaren Verbindungen werden solche bevorzugt, die bereits bei Raumtemperatur oder wenig erhöhter Temperatur gespalten werden. Hierzu gehören Ketale und vor allem Orthocarbonsäureester. Die säurespaltbare Verbindung ist in der lichtempfindlichen Schicht im allgemeinen in einer Menge von 10 bis 70, bevorzugt von 20 bis 50 Gew.-% enthalten.

Das organische polymere Bindemittel (B1) soll der Schicht Homogenität und Festigkeit verleihen. Geeignete Bindemittel sind Styrol/Maleinsäureanhydrid- und Styrol/Maleinsäurehalbester-Copolymere` Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 10 bis 75, vorzugsweise 15 bis 50 Gew.-%, bezogen auf das Gewicht der festen Schicht.

Als farbgebende Komponente (B2) enthält die lichtempfindliche Schicht einen Farbstoff oder bevorzugt ein Farbpigment, das anorganisch oder organisch sein kann. Wenn Farbstoffe eingesetzt werden, sollten sie bevorzugt lichtecht sein.

Der Farbstoff oder das Farbpigment kann z.B. Permanentgelb G (C.I. 21 095), Permanentgelb GR (C.I. 21 100), Permanentgelb DHG (C.I. 21 090), Permanentrubin L6B (C.I. 15 850 : 1), Permanent Pink F3B (C.I. 12 433), ^{(R)} Hostaperm Pink E (C.I. 73 915), ^{(R)} Hostaperm Rotviolett ER (C.I. 46 500), Permanentcarmin FBB (C.I. 12 485), ^{(R)} Hostapermblau B2G (C.I. 74 160), ^{(R)} Hostapermblau A2R (C.I. 74 160) oder ^{(R)} Printex 25 (Ruß) sein. Die Pigmente und Farbstoffe können ggf. zur Erzielung des gewünschten Farbtons abgemischt werden. Die Pigmente werden im allgemeinen zusammen mit einem Teil des Bindemittels in einem geeigneten Lösemittel dispergiert und angeteigt. Die mittlere Partikelgröße liegt i.a. unterhalb 1 µm, bevorzugt unterhalb 0,2 µm. Pigmente werden im allgemeinen gegenüber Farbstoffen bevorzugt. Der Farbstoff bzw. das Farbpigment ist in der Schicht gewöhnlich in einer Menge von 10 bis 50, bevorzugt 15 bis 35 Gew.-%, bezogen auf die nichtflüchtigen Bestandteile enthalten.

Als weitere Bestandteile kann die Schicht Inhibitoren für die thermische Zersetzung der säurespaltbaren Verbindungen, spektrale Sensibilisatoren, Weichmacher, Oligomere, oberflächenaktive Verbindungen, inerte Füllstoffe, optische Aufheller, Lichthofschutzmittel, Indikatorfarbstoffe, hydrophile Verbindungen und Restlöser enthalten. Die lichtempfindliche Schicht hat im allgemeinen ein Schichtgewicht von 0,05 bis 5, bevorzugt von 0,2 bis 1 g/m².

Die Haftschicht (C) enthält ein thermoplastisches Polymeres und ggf. weitere Bestandteile. Sie hat die Eigenschaft, bei Erwärmen auf eine Temperatur im Bereich von 60 bis 130 °C klebrig zu werden. Sie wird aus Lösung oder Dispersion oder durch Laminieren auf die farbige lichtempfindliche Schicht (B) aufgebracht. Geeignete Lösemittel, die die Schicht (B) nicht anlösen, sind gesättigte Kohlenwasserstoffe, z.B. Cyclohexan, n-Hexan und n-Heptan; Wasser oder Gemische von Wasser mit mischbaren organischen Lösemitteln. (Meth)acrylsäurecopolymere mit hoher Säurezahl oder Vinylacetat/Crotonsäure-Copolymere lassen sich aus wäßrigen, z.B. wäßrig-ammoniakalischen Lösungen aufbringen. Andere Polymere können aus wäßrigen Dispersionen aufgebracht werden, z.B. Vinylacetatpolymere. Wieder andere Polymere können aus der Schmelze aufgebracht werden, z.B. Ethylen/Vinylacetat-Copolymere. Die Haftschicht kann auch in der Weise auf die farbige lichtempfindliche Schicht (B) aufgebracht werden, daß sie auf einem temporären Schichtträger hergestellt und von dort durch Laminieren und Abziehen des temporären Trägers auf die lichtempfindliche Schicht übertragen wird.

Die Haftschicht kann auch von dem temporären Träger auf das Bildempfangsblatt (D) durch Laminieren und Abziehen übertragen werden. Danach wird das lichtempfindliche Material aus Trägerfolie (A) und farbiger lichtempfindlicher Schicht (B) mit der letzteren auf die auf dem Bildempfangsblatt befindliche Haftschicht laminiert. Für diese Art der Übertragung eignen sich Haftschichten aus (Meth)acrylesterpolymeren und insbesondere Vinylacetatpolymeren mit einem Erweichungsbereich von 80 bis 180 °C.

Das thermoplastische Polymere ist in der Haftschicht vorzugsweise in einem Anteil von mehr als 50 Gew.-% enthalten. Diese hat im allgemeinen eine Erweichungstemperatur im Bereich von 40 bis 200, insbesondere 60 bis 120 °C. Die Haftschicht kann ferner UV-Absorber, antistatische Zusätze, inerte Füllstoffe, optische Aufheller, Zusätze zur Erhöhung der Klebrigkeit und Weichmacher enthalten. Geeignete Haftschichten sind in der US-A 5 049 476 und den älteren deutschen Patentanmeldungen P 42 04 950.4 und P 42 43 253.7 beschrieben. Die Haftschicht ist allgemein dicker als 1 µm; sie hat zumeist ein Schichtgewicht von 2 bis 30, vorzugsweise von 4 bis 12 g/m².

Als flexible transparente Trägerfolien (A) für das erfindungsgemäße Material sind insbesondere solche Kunststoffolien geeignet, die beim Erwärmen auf etwa 60 bis 130 °C maßbeständig sind. Hierfür kommen vorzugsweise Folien aus Polyestern, Polycarbonaten, Polyimiden und ähnlichen Polymeren in Betracht; Polyesterfolien werden im allgemeinen bevorzugt. Die Trägerfolie kann eine Dicke im Bereich von etwa 10 bis 120, vorzugsweise von 25 bis 75 µm aufweisen. Zur Verbesserung der Maßbeständigkeit werden die Folien im allgemeinen biaxial verstreckt und ggf. thermofixiert. Die Oberfläche der Folie kann glatt oder mattiert sein, glatte Folien werden zumeist bevorzugt. Sie kann einer das Blocken verhindernden Behandlung unterworfen werden, z. B. durch Beschichten mit einer geeigneten Unterschicht, die feinteilige organische oder insbesondere anorganische Partikel enthält, deren Größe, Menge und Brechungsindex so bemessen sind, daß die Transparenz der Folie nicht beeinträchtigt ist.

Das Bildempfangsblatt (D) kann aus jedem geeigneten Material bestehen, das den Bedingungen des Laminierens und Auseinanderziehens widersteht und das einen geeigneten visuellen Kontrast zu dem übertragenen Farbbbild bildet. Normalerweise sollte das Material weiß sein. Kunstoffolien, z.B. pigmentierte Polyesterfolien, kunststoffbeschichtete Papiere, z.B. mit Polyethylen beschichtetes Papier, Holz, Glas, Metall und dgl. können verwendet werden. Das Material kann eine haftvermittelnde Vorbeschichtung tragen. Auch kann ein normales Bedruckpapier eingesetzt werden.

Das Laminieren erfolgt, indem das lichtempfindliche Material mit seiner Haftschicht auf das Empfangsblatt aufgelegt und mit diesem zusammen durch den Spalt von zwei beheizten Laminierwalzen unter ausreichendem Druck geführt wird. Die Laminiertemperatur liegt gewöhnlich im Bereich von 60 bis 130, bevorzugt 70 bis 120 °C. Die Walzen können die gleiche oder verschiedene Temperatur haben; die Laminiergeschwindigkeit liegt gewöhnlich zwischen 10 und 100, bevorzugt bei 20 bis 60 cm/min.

Die lichtempfindliche Schicht wird in bekannter Weise durch die transparente Trägerfolie (A) vor oder nach dem Laminieren belichtet. Die Belichtung erfolgt gewöhnlich unter einem negativen Rasterfarbauszug im Vakuumkopierrahmen. Als Lichtquellen werden Quecksilberdampflampen bevorzugt. Lichtabsorptionsfilter können zur Verminderung von Streulicht eingesetzt werden.

Nach dem Laminieren und Belichten wird das Bild durch gleichmäßiges Abziehen der Trägerfolie von dem Empfangsblatt bei Raumtemperatur entwickelt. Besondere Vorrichtungen zum Nieder- oder Festhalten des Empfangsblattes während des Abziehens sind nicht erforderlich, weil nur mäßige Abziehkräfte nötig sind. Der Abziehwinkel sollte mindestens 90 ° betragen. Bei dem Abziehen werden die unbelichteten Bereiche der lichtempfindlichen Schicht mit der Trägerfolie entfernt, und die belichteten Bereiche verbleiben mit der gesamten Hattschicht auf dem Bildempfangsblatt. Dort wird somit ein negatives Bild der Vorlage erhalten.

Ein weiteres lichtempfindliches Material mit einer andersfarbigen lichtempfindlichen Schicht (B) wird mittels einer Haftschicht (C) auf das erste Teilfarbenbild laminiert und durch den entsprechenden Farbauszug im Register zum ersten Teilfarbenbild belichtet. Das zweite Teilfarbenbild wird in gleicher Weise durch Abziehen der Trägerfolie entwickelt. In gleicher Weise kann ein drittes und viertes Teilfarbenbild hinzugefügt werden. Gewöhnlich wird ein Vierfarbenbild aus den Grundfarben Cyan, Magenta, Gelb und Schwarz aufgebaut. Wenn es gewünscht wird, kann die Oberfläche des fertigen Bildes eine matte Texturierung erhalten, z.B. indem die glänzende Oberfläche im Kontakt mit einer rauhen Oberfläche, z.B. einer mattierten Folie verprägt wird. Dazu werden das Bild und die mattierte Folie zusammen durch einen Walzenspalt eines Laminiergerätes geführt. Durch Auswahl eines entsprechenden mattierten Materials kann die Oberflächentexturierung bestimmt werden. Zum Abschluß kann das fertige Bild durch Ausbelichten mit einer geeigneten Lichtquelle, ggf. unter Erwärmen gehärtet werden. Eine Schutzschicht, wie sie z.B. in der US-A 4 999 266 beschrieben ist, kann auch auf die Oberfläche des fertigen Bildes laminiert werden. Das fertige Bild kann auch von einem temporären Träger auf einen permanenten Träger übertragen werden, wie es in der US-A 5 192 630 beschrieben ist.

Die folgenden Beispiele erläutern bevorzugte Ausführungsformen der Erfindung. Die Mengen sind zumeist in Gewichtsteilen (Gt) angegeben. Mengenverhältnisse und Prozente sind, wenn nichts anderes angegeben ist, in Gewichtseinheiten zu verstehen.

### Beispiel 1

Auf vier 50 µm dicke biaxial verstreckte und thermofixierte Polyethylenterephthalatfolien, die mit einer Antiblockausrüstung versehen waren, wurde jeweils eine der folgenden Beschichtungslösungen für die Grundfarben Cyan, Gelb, Magenta und Schwarz aufgebracht:

| | Cyan Gt | Gelb Gt | Magenta Gt | Schwarz Gt |
|---|---|---|---|---|
| Polymerer Orthoester* | 2,02 | 2,01 | 1,96 | 1,94 |
| 2-(4-Biphenylyl)-4,6-bis-trichlormethyl-s-triazin | 0,51 | 0,50 | 0,43 | 0,52 |
| Polyvinylformal mittl.Molekulargewicht 80.000, 24 % Vinylalkoholeinheiten, 26 % Vinylacetateinheiten und 50 % Vinylformaleinheiten (^{(R)}Formvar 12/85) | 2,15 | 1,79 | 1,57 | 2,20 |
| ^{(R)}Hostapermblau B2G (C.I. 74 160) | 0,90 | - | - | - |
| Permanentgelb GR (G.I. 21 100) | - | 0,95 | - | - |
| Permanentcarmin FBB (G.I. 12 485) | - | - | 1,21 | - |
| Ruß (^{(R)}Printex 25) | - | - | - | 1,30 |
| Tetrahydrofuran | 34,81 | 34,61 | 33,67 | 33,37 |
| 1-Methoxy-2-propanol | 23,58 | 23,45 | 22,81 | 22,61 |
| γ-Butyrolacton | 7,22 | 7,63 | 9,71 | 10,41 |
| Toluol | 1,87 | 1,86 | 1,81 | 1,79 |

| | | | | |
|---|---|---|---|---|
| * hergestellt durch Umsetzen von Orthoameisensäuretrimethylester mit 4-Oxa-6,6-bis-hydroxymethyl-Octan-1-ol | | | | |

Die Farbpigmente wurden als Dispersionen in die Lösungen eingebracht. Dazu wurden sie zusammen mit einem Teil des Polyvinylformals in Butyrolacton dispergiert und zu der gewünschten Teilchengröße, d.h. einem mittleren Teilchendurchmesser von 0,1 µm vermahlen. Vor dem Beschichten wurde jede Beschichtungslösung gut vermischt. Die Beschichtungen wurden 2 Minuten bei 70 °C getrocknet; danach hatten die optischen Dichten der einzelnen Schichten die folgenden Werte:

| | |
|---|---|
| Cyan | 1,3 |
| Gelb | 1,0 |
| Magenta | 1,4 |
| Schwarz | 1,6 |

Die Schichtgewichte betrugen 0,5 g/m².

Auf die Farbschichten wurde jeweils eine Haftschichtlösung der folgenden Zusammensetzung aufgebracht:

| | Gt |
|---|---|
| Ammoniumhydroxid (25 %) | 8,5 |
| Natriumsulfit | 1,4 |
| Polyvinylmethylether (^{(R)} Lutonal M 40) | 1,9 |
| Copolymer Vinylacetat/Crotonsäure 95 : 5) | 96,7 |
| Wasser | 520,0 |
| Ethanol | 43,0 |

Nach dem Trocknen hatten die Haftschichten jeweils ein Gewicht von 6,5 g/m².

Die Cyanfolie wurde bei 105 °C mit ihrer Haftschicht auf ein Empfangsblatt aus Papier laminiert. Das lichtempfindliche Material wurde dann unter einem Cyan-Negativ-Farbauszug durch die Trägerfolie mittels einer 5 000 W Kopierlampe belichtet. Nach dem Belichten wurde die Trägerfolie von dem Empfangsblatt abgezogen, wobei die unbelichteten Stellen der Farbschicht an der Trägerfolie hafteten und die belichteten Stellen zusammen mit der gesamten Haftschicht auf dem Empfangsblatt verblieben.

Die gelbe lichtempfindliche Farbfolie wurde in gleicher Weise auf das Cyan-Teilfarbenbild laminiert, dann unter dem entsprechenden Gelb-Farbauszug belichtet und durch Abziehen der Trägerfolie zum gelben Teilfarbenbild entwickelt. Diese Verfahrensschritte wurden entsprechend mit der Magenta- und der Schwarz-Farbfolie wiederholt. Es wurde eine genaue Vierfarben-Reproduktion des Originals erhalten.

Die Punktwiedergabe betrug mindestens 2 bis 99 % in einem Raster von 60 Linien je cm. Die Belichtungszeiten lagen zwischen etwa 20 und 30 Sekunden.

### Beispiele 2 bis 9

Beispiel 1 wurde mit unterschiedlichen Photoinitiatoren in der lichtempfindlichen Schicht wiederholt. In der folgenden Tabelle sind die Photoinitiatoren, die Lage ihres Absorptionsmaximums in nm und der Extinktionskoeffizient (E) bei dieser Wellenlänge angegeben.

| Beispiel | Photoinitiator | λₘₐₓ(µm) | E |
|---|---|---|---|
| 1 | 2-(4-Biphenylyl)-4,6-bis-trichlormethyl-s-triazin | 332 | 30.800 |
| 2 | 4,4'-Bis-[2,4-bis-trichlormethyltriazinyl-(6)-]diphenylether | 331 | 50.500 |
| 3 | 2-(4-Ethoxyphenyl)-4,6-bis-trichlormethyl-s-triazin | 333 | 28.200 |
| 4 | 2-Styryl-4,6-bis-trichlormethyl-s-triazin | 336 | 30.800 |
| 5 | 2-(3,4,5-Trimethoxy-phenyl)-4,6-bis-trichlormethyl-s-triazin | 337 | 15.900 |

| Beispiel | Photoinitiator | λₘₐₓ(µm) | E |
|---|---|---|---|
| 6 | 2-(3,4-Dimethoxy-phenyl)-4,6-bis-trichlormethyl-s-triazin | 352 | 17.700 |
| 7 | 2-Fluoren-2-yl-4,6-bis-trichlormethyl-s-triazin | 356 | 37.800 |
| 8 | 2-(4-Styrylphenyl)-4,6-bis-trichlormethyl-s-triazin | 371 | 41.400 |
| 9 | 2-(4-Ethoxy-naphth-1-yl)-4,6-bis-trichlormethyl-s-triazin | 388 | 25.000 |

### Beispiel 10

Beispiel 1 wurde mit der Abwandlung wiederholt, daß die lichtempfindlichen Gemische auf die unbehandelte Seite von 75 µm dicken Polyesterfolien aufgebracht wurden. Die Punktwiedergabe betrug nur 3 bis 97 %, weil hier durch die dickere Folie belichtet wurde.

### Beispiel 11

Beispiel 1 wurde mit der Abwandlung wiederholt, daß der polymere Orthoester durch ein Polyacetal ersetzt wurde, das durch Umsetzen von 2-Ethyl-butyraldehyd mit Triethylenglykol erhalten worden war. Es wurde ein Mehrfarbenbild ähnlicher Qualität wie in Beispiel 1 erhalten.

### Beispiel 12

Beispiel 1 wurde wiederholt, jedoch wurde das Lösemittelgemisch von Tetrahydrofuran und 1-Methoxy-2-propanol durch die gleiche Menge eines Gemischs aus Butanon, 1-Methoxy-2-propanol und 4-Hydroxy-4-methyl-2-pentanon im Verhältnis 35:20:25 ersetzt. Die erhaltenen Lösungen waren gegen Peroxidbildung beständig und ergaben ein vergleichbares Mehrfarbenbild.

### Beispiel 13

Beispiel 1 wurde wiederholt, jedoch wurde das Polyvinylformal durch die gleiche Menge eines Polyvinylbutyrals mit einem Molekulargewicht von 70.000 bis 80.000 ersetzt, das 71 % Vinylbutyraleinheiten, 2 % Vinylacetateinheiten und 27 % Vinylalkoholeinheiten enthielt. Die zum Trennen der Folie von dem Bildempfangsmaterial und damit zur Bildentwicklung erforderliche Kraft war etwas größer als bei dem Polyvinylformal von Beispiel 1. Das erhaltene Mehrfarbenbild war im wesentlichen von gleicher Qualität.

### Beispiel 14

Beispiel 1 wurde wiederholt mit der Abwandlung, daß die folgende Haftschichtlösung eingesetzt wurde:

| | |
|---|---|
| 31,7 Gt | Vinylpyrrolidon/Vinylacetat-Copolymeres (1:1), |
| 90,2 Gt | Wasser, |
| 10,2 Gt | Ethanol. |

Es wurde im wesentlichen das gleiche Ergebnis wie in Beispiel 1 erhalten.

## Patentansprüche

1. Lichtempfindliches Material mit
(A) einer flexiblen transparenten Trägerfolie,
(B) einer farbigen lichtempfindlichen Schicht, die ein organisches Bindemittel (B1) und einen Farbstoff oder ein Farbpigment (B2) enthält, und
(C) einer Haftschicht, die ein thermoplastisches Polymeres enthält und eine Erweichungstemperatur im Bereich von 40 bis 200 °C hat,
wobei die Haftung (a₁) der unbelichteten lichtempfindlichen Schicht (B) an der Haftschicht (C) kleiner ist als die Haftung (a₃) der unbelichteten lichtempfindlichen Schicht (B) an der Trägerfolie (A) und als die Kohäsionen der Schichten (B) und (C) und wobei die Haftung (a₃') der belichteten lichtempfindlichen Schicht (B) an der Trägerfolie (A) kleiner ist als die Haftung (a₁') der belichteten lichtempfindlichen Schicht (B) an der Haftschicht (C) sowie als die Kohäsionen der Haftschicht (C) und der belichteten lichtempfindlichen Schicht (B), dadurch gekennzeichnet, daß die farbige lichtempfindliche Schicht (B) ferner eine Verbindung (83), die bei Bestrahlung eine starke Säure bildet, und eine Verbindung (B4) enthält, die mindestens eine durch Säure spaltbare Gruppe aufweist.

2. Lichtempfindliches Material nach Anspruch 1, dadurch gekennzeichnet, daß die Verbindung (B3) mindestens eine Trihalogenmethylgruppe enthält.

3. Lichtempfindliches Material nach Anspruch 1, dadurch gekennzeichnet, daß die durch Säure spaltbare Gruppe der Verbindung (B4) eine C-O-C-Gruppe ist.

4. Lichtempfindliches Material nach Anspruch 1, dadurch gekennzeichnet, daß die Verbindung (B4) ein Orthocarbonsäureester, ein Acetal oder Ketal ist.

5. Lichtempfindliches Material nach Anspruch 1, dadurch gekennzeichnet, daß die Oberfläche der transparenten Trägerfolie (A), auf der sich die lichtempfindliche Schicht (B) befindet, zur Verhinderung des Blockens vorbehandelt ist.

6. Lichtempfindliches Material nach Anspruch 1, dadurch gekennzeichnet, daß die lichtempfindliche Schicht (B) ein Gewicht von 0,05 bis 5 g/m² hat.

7. Lichtempfindliches Material nach Anspruch 1, dadurch gekennzeichnet, daß die Haftschicht (C) ein Gewicht von 2 bis 30 g/m² hat.

8. Verfahren zur Herstellung eines farbigen Bilds, bei dem man ein lichtempfindliches Material aus
(A) einer flexiblen transparenten Trägerfolie,
(B) einer farbigen lichtempfindlichen Schicht, die ein organisches Bindemittel (B1) und einen Farbstoff oder ein Farbpigment (B2) enthält, und
(C) einer Haftschicht, die ein thermoplastisches Polymeres enthält und eine Erweichungstemperatur im Bereich von 40 bis 200 °C hat,
mit der Haftschicht (C) unter Druck und bei erhöhter Temperatur auf ein Bildempfangsblatt (D) laminiert, das erhaltene Laminat durch die Trägerfolie (A) hindurch bildmäßig belichtet und die Trägerfolie zusammen mit den unbelichteten Schichtbereichen der lichtempfindlichen Schicht (B) von dem Bildempfangsblatt (D) abzieht, wobei die Haftung (a₁) der unbelichteten lichtempfindlichen Schicht (B) an der Haftschicht (C) kleiner ist als die Haftung (a₂) der Haftschicht (C) an dem Bildempfangsblatt (D) und die Haftung (a₃) der unbelichteten lichtempfindlichen Schicht (B) an der Trägerfolie (A) und als die Kohäsionen der Schichten (B) und (C) und wobei die Haftung (a₃') der belichteten lichtempfindlichen Schicht (B) an der Trägerfolie (A) kleiner ist als die Haftung (a₂) der Haftschicht (C) an dem Bildempfangsblatt (D) und die Haftung (a₁') der belichteten lichtempfindlichen Schicht (B) an der Haftschicht (C) sowie als die Kohäsionen der Haftschicht (C) und der belichteten lichtempfindlichen Schicht (B), dadurch gekennzeichnet, daß man ein lichtempfindliches Material mit einer farbigen lichtempfindlichen Schicht (B) einsetzt, die eine Verbindung (B3), die bei Bestrahlung eine starke Säure bildet, und eine Verbindung (B4) enthält, die mindestens eine durch Säure spaltbare Gruppe aufweist.

9. Verfahren nach Anspruch 8, dadurch gekennzeichnet, daß man die Schritte Laminieren, Belichten und Abziehen der Trägerfolie mit mindestens einem lichtempfindlichen Material, das einen anderen Farbstoff enthält, auf dem gleichen Bildempfangsblatt wiederholt.

10. Verfahren nach Anspruch 8, dadurch gekennzeichnet, daß man das lichtempfindliche Material bei einer Temperatur im Bereich von 60 bis 130 °C auf das Bildempfangsblatt laminiert.

## Claims

1. A light-sensitive material having
(A) a flexible transparent supporting film,
(B) a coloured light-sensitive layer which contains an organic binder (B1) and a dye or a coloured pigment (B2), and
(C) an adhesive layer which contains a thermoplastic polymer and has a softening temperature within the range of from 40 to 200°C,
with the adhesion (a₁) of the unexposed light-sensitive layer (B) to the adhesive layer (C) being less than the adhesion (a₃) of the unexposed light-sensitive layer (B) to the supporting film (A) and than the mutual cohesion of the layers (B) and (C), and with the adhesion (a₃') of the exposed light-sensitive layer (B) to the supporting film (A) being less than the adhesion (a₁') of the exposed light-sensitive layer (B) to the adhesive layer (C) and than the mutual cohesion of the adhesive layer (C) and of the exposed light-sensitive layer (B), characterised in that the coloured light-sensitive layer (B) contains in addition a compound (B3), which on exposure to light forms a strong acid, and a compound (B4) possessing at least one group which can be split by acid.

2. The light-sensitive material according to claim 1, characterised in that the compound (B3) contains at least one trihalomethyl group.

3. The light-sensitive material according to claim 1, characterised in that the group which is contained in the compound (B4) and can be split by acid is a -C-O-C- group.

4. The light-sensitive material according to claim 1, characterised in that the compound (B4) is an orthocarboxylic ester, an acetal or ketal.

5. The light-sensitive material according to claim 1, characterised in that the surface of the transparent supporting film (A), whereon the light-sensitive layer (B) is situated, is pretreated in order to prevent blocking.

6. The light-sensitive material according to claim 1, characterised in that the light-sensitive layer (B) has a weight of from 0.05 to 5 g/m².

7. The light-sensitive material according to claim 1, characterised in that the adhesive layer (C) has a weight of from 2 to 30 g/m².

8. A process for the production of a coloured image, whereby a light-sensitive material composed of
(A) a flexible transparent supporting film,
(B) a coloured light-sensitive layer which contains an organic binder (B1) and a dye or a coloured pigment (B2), and
(C) an adhesive layer which contains a thermoplastic polymer and has a softening temperature within the range of from 40 to 200°C,
is laminated onto an image-receiving sheet (D), with the adhesive layer (C) being under pressure and at elevated temperature, the laminate obtained is exposed imagewise through the supporting film (A) and the supporting film together with the unexposed regions of the light-sensitive layer (B) are peeled off from the image-receiving sheet (D), with the adhesion (a₁) of the unexposed light-sensitive layer (B) to the adhesive layer (C) being less than the adhesion (a₂) of the adhesive layer (C) to the image-receiving sheet (D) and than the adhesion (a₃) of the unexposed light-sensitive layer (B) to the supporting film (A) and than the mutual cohesion of the layers (B) and (C), and with the adhesion (a₃') of the exposed light-sensitive layer (B) to the supporting film (A) being less than the adhesion (a₂) of the adhesive layer (C) to the image-receiving sheet (D) and than the adhesion (a₁') of the exposed light-sensitive layer (B) to the adhesive layer (C) and than the mutual cohesion of the adhesive layer (C) and of the exposed light-sensitive layer (B), characterised in that a light-sensitive material having a coloured light-sensitive layer (B) is used, which layer contains a compound (B3), which on exposure to light forms a strong acid, and a compound (B4) possessing at least one group which can be split by acid.

9. The process according to claim 8, characterised in that the stages of laminating, exposure to light and peeling off from the supporting film having at least one light-sensitive material containing another dye, are repeated on the same image-receiving sheet.

10. The process according to claim 8, characterised in that the light-sensitive material is laminated onto the image-receiving sheet at a temperature in the range of from 60 to 130°C.

## Revendications

1. Matériau photosensible comprenant
(A) une feuille de support flexible et transparente,
(B) une couche photosensible colorée qui contient un liant organique (B1) et un colorant ou un pigment chromogène (B2), et
(C) une couche adhésive qui contient un polymère thermoplastique et qui possède une température de ramollissement dans le domaine de 40 à 200°C,
dans lequel l'adhérence (a₁) de la couche photosensible non exposée (B) à la couche adhésive (C) est inférieure à l'adhérence (a₃) de la couche photosensible non exposée (B) à la feuille de support (A) et inférieure aux cohésions des couches (B) et (C), et dans lequel l'adhérence (a₃') de la couche photosensible exposée (B) à la feuille de support (A) est inférieure à l'adhérence (a₁') de la couche photosensible exposée (B) à la couche adhésive (C) et inférieure aux cohésions de la couche adhésive (C) et de la couche photosensible exposée (B), caractérisé en ce que la couche photosensible colorée (B) contient en outre un composé (B3) qui, lors de l'exposition, forme un acide fort, et un composé (B4) qui présente au moins un groupe apte à être séparé par un acide.

2. Matériau photosensible selon la revendication 1, caractérisé en ce que le composé (B3) contient au moins un groupe trihalogénométhyle.

3. Matériau photosensible selon la revendication 1, caractérisé en ce que le groupe du composé (B4), apte à être séparé par un acide, est un groupe C-O-C-.

4. Matériau photosensible selon la revendication 1, caractérisé en ce que le composé (B) est un ester orthocarboxylique, un acétal ou un cétal.

5. Matériau photosensible selon la revendication 1, caractérisé en ce que la surface de la feuille de support transparente (A), sur laquelle se trouve la couche photosensible (B), est soumise à un prétraitement pour empêcher le blocage.

6. Matériau photosensible selon la revendication 1, caractérisé en ce que la couche photosensible (B) a un poids de 0,05 à 5 g/m².

7. Matériau photosensible selon la revendication 1, caractérisé en ce que la couche adhésive (C) a un poids de 2 à 30 g/m².

8. Procédé pour la préparation d'un image en couleurs, dans lequel on stratifie un matériau photosensible constitué par
(A) une feuille de support flexible et transparente,
(B) une couche photosensible colorée qui contient un liant organique (B1) et un colorant ou un pigment chromogène (B2), et
(C) une couche adhésive qui contient un polymère thermoplastique et qui possède une température de ramollissement dans le domaine de 40 à 200°C,
avec la couche adhésive (C) sous pression et à température élevée, sur une feuille réceptrice d'image (D), on expose en forme d'image le stratifié obtenu à travers la feuille de support (A) de part en part, et on retire de la feuille réceptrice d'image (D) la feuille de support conjointement avec les zones non exposées de la couche photosensible (B), dans lequel l'adhérence (a₁) de la couche photosensible non exposée (B) à la couche adhésive (C) est inférieure à l'adhérence (a₂) de la couche adhésive (C) à la feuille réceptrice d'image (D) et à l'adhérence (a₃) de la couche photosensible non exposée (B) à la feuille de support (A) et inférieure aux cohésions des couches (B) et (C), et dans lequel l'adhérence (a₃') de la couche photosensible exposée (B) à la feuille de support (A) est inférieure à l'adhérence (a₃) de la couche adhésive (C) à la feuille réceptrice d'image (D) et à l'adhérence (a₁') de la couche photosensible exposée (B) à la couche adhésive (C) et inférieure aux cohésions de la couche adhésive (C) et de la couche photosensible exposée (B), caractérisé en ce qu'on met en oeuvre un matériau photosensible contenant une couche photosensible colorée (B) qui contient un composé (B3) qui, lors de l'exposition, forme un acide fort, et un composé (B4) qui présente au moins un groupe qui peut être séparé à l'aide d'un acide.

9. Procédé selon la revendication 8, caractérisé en ce qu'on répète les étapes de stratification, d'exposition et de séparation par traction de la feuille de support, avec au moins un matériau photosensible qui contient un autre colorant, sur la même feuille réceptrice.

10. Procédé selon la revendication 8, caractérisé en ce qu'on stratifie le matériau photosensible sur la feuille de réception d'image à une température dans le domaine de 60 à 130° C.
